# EUROPEAN PATENT APPLICATION

(11) **EP 4 498 412 A2**
(43) Date of publication of application: **29.01.2025**
(21) Application number: 24181814.5
(22) Date of filing: 12.06.2024
(51) Int. Cl.: H01L 21/677

(54) **SUBSTRATE CASSETTE HANDLING APPARATUS, SUBSTRATE PROCESSING APPARATUS, SUBSTRATE PROCESSING METHOD AND PROGRAM**

(30) Priority: 30.06.2023 JP 2023107930
(71) Applicant: Kokusai Electric Corp., Tokyo 1010045 (JP)
(72) Inventor: HAYASHI, Akinari, Toyama-shi, 939-2393 (JP); TEZUKA, Shigenori, Toyama-shi, 939-2393 (JP); KURODA, Atsuko, Toyama-shi, 939-2393 (JP); KUROSAWA, Toshiharu, Toyama-shi, 939-2393 (JP)
(74) Representative: Verscht, Thomas Kurt Albert

(57) **Abstract**

To improve an accuracy of detecting whether an orientation of a substrate is correct, there is provided a technique that includes: a stage where a cassette accommodating substrates is placed, wherein the substrates are provided with orientation indicators; a reflector provided at a first end of an optical path set to enable a light to pass therethrough without hitting the substrates when the orientation indicators of the substrates are oriented in a predetermined direction; a robot configured to transfer the cassette between the stage and a shelf, and including a reflective optical sensor configured to emit the light along the optical path and to detect the light reflected from the reflector; and a controller controlling the robot to move the reflective optical sensor to a position corresponding to the optical path when checking whether the orientation indicators of the substrates on the stage are aligned in the predetermined direction.

## Description

### [Technical Field]

The present disclosure relates to a substrate cassette handling apparatus, a substrate processing apparatus, a substrate processing method and a program.

### [Related Art]

In a cassette delivery structure (cassette transfer structure) on which a wafer cassette is placed, an orientation flat alignment is performed to align an orientation flat indicating a crystal orientation of a wafer serving as a substrate. According to some related arts, an orientation flat confirmation sensor may be provided at a placement table (mounting table) to detect whether orientation flats of a plurality of wafers are aligned before performing the orientation flat alignment (for example, see Patent Document 1).

For example, the cassette transfer structure may handle substrates of different diameters and materials. However, a light transmittance or dimensions such as an orientation flat of each substrate may be different depending on a diameter and material of each substrate. Thereby, it may reduce a detection accuracy of a sensor (for example, the orientation flat confirmation sensor described above) configured to check whether an orientation of the substrate is correct.

### [Related Art Document]

### [Patent Document]

Patent Document 1: Japanese Patent Laid-Open No. 2002-270675

### [Disclosure]

### [Technical Problem]

According to the present disclosure, there is provided a technique capable of improving an accuracy of detecting whether an orientation of a substrate is correct.

### [Technical Solution]

According to an aspect of the present disclosure, there is provided a technique that includes a stage on which a cassette accommodating a plurality of substrates is placed, wherein the plurality of substrates are provided with orientation indicators, respectively; a reflector provided at a first end of a predetermined optical path, wherein the predetermined optical path is set so as to enable a light to pass therethrough without hitting the plurality of substrates when each of the orientation indicators of the plurality of substrates is oriented in a predetermined direction; a robot configured to transfer the cassette between the stage and a shelf provided in the substrate cassette handling apparatus, and including a reflective optical sensor configured to emit the light along the optical path and to detect the light reflected from the reflector; and a controller configured to be capable of controlling the robot to move the reflective optical sensor to a position corresponding to the optical path when checking whether or not the orientation indicators of the plurality of substrates on the stage are aligned in the predetermined direction.

### [Advantageous Effects]

According to some embodiments of the present disclosure, it is possible to improve the accuracy of detecting whether the orientation of the substrate is correct.

### [Brief Description of Drawings]

FIG. 1 is a diagram schematically illustrating a substrate processing apparatus according to one or more embodiments of the present disclosure.
FIG. 2 is a diagram schematically illustrating a perspective view of a cassette stage and a cassette transfer structure according to the embodiments of the present disclosure.
FIG. 3 is a diagram schematically illustrating an orientation flat confirmation using a reflective optical sensor.
FIG. 4 is a diagram illustrating a retroreflective sensor.
FIG. 5 is a diagram schematically illustrating a perspective view of the cassette transfer structure according to the embodiments of the present disclosure.
FIG. 6 is a diagram schematically illustrating a perspective view of a comb-shaped sensor and a wafer posture aligner provided on the cassette stage.
FIG. 7A is a diagram schematically illustrating a part of a process flow of a substrate processing method according to the embodiments of the present disclosure.
FIG. 7B is a diagram schematically illustrating another part of the process flow of the substrate processing method according to the embodiments of the present disclosure.
FIG. 8 is a diagram schematically illustrating a wafer mapping using the reflective optical sensor.
FIG. 9 is a diagram schematically illustrating a detailed process flow of an orientation flat confirmation according to a modified example.

### [Detailed Description]

### <Embodiments of Present Disclosure>

Hereinafter, one or more embodiments (also simply referred to as "embodiments") according to the technique of the present disclosure will be described with reference to the drawings. The drawings used in the following descriptions are all schematic. For example, a relationship between dimensions of each component and a ratio of each component shown in the drawing may not always match the actual ones. Further, even between the drawings, the relationship between the dimensions of each component and the ratio of each component may not always match. In addition, the same or similar reference numerals represent the same or similar components in the drawings. Thus, each component is described with reference to the drawing in which it first appears, and redundant descriptions related thereto will be omitted unless particularly necessary. Further, the number of each component described in the present specification is not limited to one, and the number of each component described in the present specification may be two or more unless otherwise specified in the present specification.

### (1) Substrate Processing Apparatus

In the present embodiments of the present disclosure, for example, a substrate processing apparatus (hereinafter, also simply referred to as a "processing apparatus") 10 is configured as a semiconductor manufacturing apparatus capable of performing a processing in a method of manufacturing a semiconductor device.

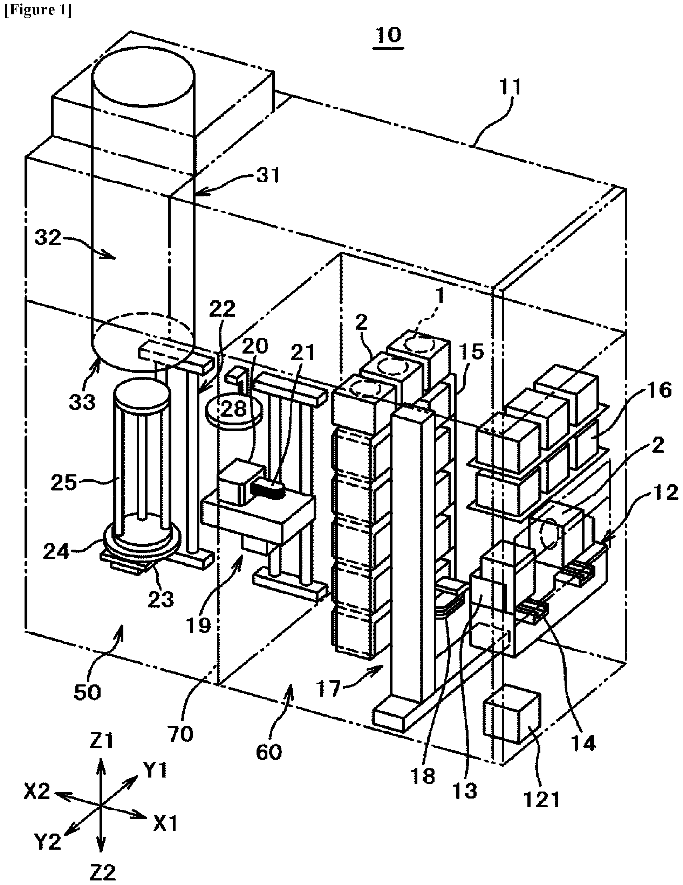

As shown in FIG. 1, the processing apparatus 10 according to the present embodiments includes a housing 11, and a cassette transfer structure 12 is provided adjacent to a front surface (that is, in an X1 direction) of the housing 11. In the drawings, an X1-X2 direction indicates a front-rear direction of the processing apparatus 10, a Y2-Y1 direction indicates a left-right direction and a Z1-Z2 direction indicates an up-down direction (vertical direction). The cassette transfer structure 12 is provided with a cassette stage device (also referred to as a "cassette loader") 13 capable of placing (or mounting) two open cassettes including an open cassette (hereinafter, also simply referred to as "cassette") 2 serving as a substrate container. Hereinafter, a plurality of cassettes (for example, the two cassettes) including the cassette 2 may also be simply referred to as "cassettes 2". The cassette 2 serves as a carrier for a wafer 1 serving as a substrate, that is, serves as a carrier for a plurality of wafers including the wafer 1. Hereinafter, the plurality of wafers including the wafer 1 may also be simply referred to as "wafers 1". For example, two sets of wafer posture aligners including a wafer posture aligner (which is a wafer posture alignment device) 14 are provided below the cassette stage device 13. Hereinafter, a plurality of wafer posture aligners (for example, the two sets of the wafer posture aligners) including the wafer posture aligner 14 may also be simply referred to as "wafer posture aligners 14". In other words, the cassette stage device 13 is provided with a plurality of stages, and each stage is configured to be capable of transferring the cassette 2 to and from an outside of an apparatus such as the processing apparatus 10.

The cassette 2 transferred by an external transfer device (not shown) is placed on a placement table (mounting table) 44 (which will be described later) of the cassette stage device 13 in a vertical posture serving as a first posture (a state in which the wafer 1 is erected vertically in the cassette 2, that is, a state in which the wafers 1 are stored in a horizontal arrangement in the cassette 2). The wafer posture aligner 14 includes an orientation aligner (which is an orientation alignment device) configured to align postures of the wafers 1 such that notches or orientation flats serving as orientation indicators of the wafers 1 stored in the cassette 2 in the vertical posture are aligned in the same direction. The cassette stage device 13 includes a cassette posture converter configured to rotate the placement table 44 by 90 ° to place the cassette 2 in a horizontal posture serving as a second posture (a state in which the wafer 1 lies horizontally in the cassette 2, that is, a state in which the wafers 1 are stored in a vertical arrangement in the cassette 2). A cassette shelf 15 is provided inside the housing 11 to face the cassette transfer structure 12, and a spare cassette shelf 16 is provided above the cassette transfer structure 12.

A cassette transfer robot 17 is provided between the cassette transfer structure 12 and the cassette shelf 15. The cassette transfer robot 17 includes a robot arm 18, and the robot arm 18 itself is configured to be movable horizontally and movable up and down. The robot arm 18 includes a hand 173 capable of moving forward and backward in the front-rear direction (that is, in the X1-X2 direction). By vertical and horizontal movements of the robot arm 18 and forward and backward movements of the hand 173, the cassette 2 in the horizontal posture on the cassette stage device 13 is configured to be taken up (scooped up) from thereunder and transferred to the cassette shelf 15 or the spare cassette shelf 16. The cassette shelf 15 and the spare cassette shelf 16 may be regarded as buffer shelves for the cassettes 2. Since the cassette stage device 13 is provided with the cassette posture converter, it is possible to perform both of an orientation alignment by the wafer posture aligner 14 and a cassette transfer by the cassette transfer robot 17.

At a rear (that is, in an X2 direction) of the cassette shelf 15, a wafer transfer device (wafer transfer structure) 19 capable of transferring the wafers 1 in the cassette 2 at once or one by one to a substrate support (hereinafter, also referred to as a "boat") 25 is provided. The wafer transfer device 19 is configured to be rotatable and movable up and down. The wafer transfer device 19 is provided with a wafer holder 20 configured to be movable forward and backward, and a plurality of wafer holding plates 21 are horizontally attached to the wafer holder 20. Hereinafter, each of the plurality of wafer holding plates 21 may also be referred to as a "wafer holding plate 21". At a rear (that is, in the X2 direction) of the wafer transfer device 19, a boat elevator 22 is provided, and a seal cap 24 configured to rotatably hold the boat 25 is provided horizontally on an arm 23 of the boat elevator 22.

The processing apparatus 10 includes a transfer chamber 50 and a cassette holding chamber 60. In the transfer chamber 50, components such as the wafer transfer device 19, the wafer holder 20, the wafer holding plate 21 and the boat elevator 22 are provided. In the cassette holding chamber 60, components such as the cassette shelf 15, the spare cassette shelf 16 and the cassette transfer robot 17 are provided. A wall structure 70 is provided between the transfer chamber 50 and the cassette holding chamber 60. The wafer transfer device (wafer transfer structure) 19 is configured to transfer the wafer 1 from the cassette 2 in the cassette holding chamber 60 to the boat 25.

For example, the processing apparatus 10 includes a reaction tube (also referred to as a "process tube") 31 made of a highly heat resistant material such as quartz glass. The reaction tube 31 is of a cylindrical shape with one end (first end) that is open and the other end (second end) that is closed, and the reaction tube 31 is vertically provided and fixedly supported such that a center line thereof is vertical. A process chamber 32 in which the wafers 1 are accommodated is constituted by a hollow cylindrical portion of the reaction tube 31, and a furnace opening 33 through which the wafer 1 is transferred is constituted by a lower end opening of the reaction tube 31. The furnace opening 33 is open with respect to the transfer chamber 50, and the process chamber 32 and the transfer chamber 50 are connected.

The seal cap 24 configured to close the furnace opening 33 is provided at a lower end surface of the reaction tube 31 such that the seal cap 24 is in contact with the lower end surface of the reaction tube 31 from thereunder in the vertical direction. The seal cap 24 is of a disk shape, and is configured to be elevated and lowered in the vertical direction by the boat elevator 22 installed outside the reaction tube 31. Further, a furnace opening shutter 28 configured to close (or seal) the furnace opening 33 when the seal cap 24 is moved to a lower end position thereof may be further provided.

The boat 25 configured to accommodate (hold or support) the wafers 1 are vertically supported on the seal cap 24. For example, the boat 25 includes a pair of end plates (that is, an upper end plate and a lower end plate) and a plurality of support columns (holding structures) (for example, three support columns according to the present embodiments) provided vertically between the pair of end plates so as to connect the pair of the end plates. A plurality of support recesses are engraved at each of the support columns at equal intervals in a lengthwise direction of each of the support columns. The support recesses located at the same stage of each of the support columns are open to face each one another. By inserting outer peripheral edges of the wafers 1 into the support recesses of the support columns related thereto, the boat 25 supports (or hold) the wafers 1 while the wafers 1 are horizontally oriented with their centers aligned with one another.

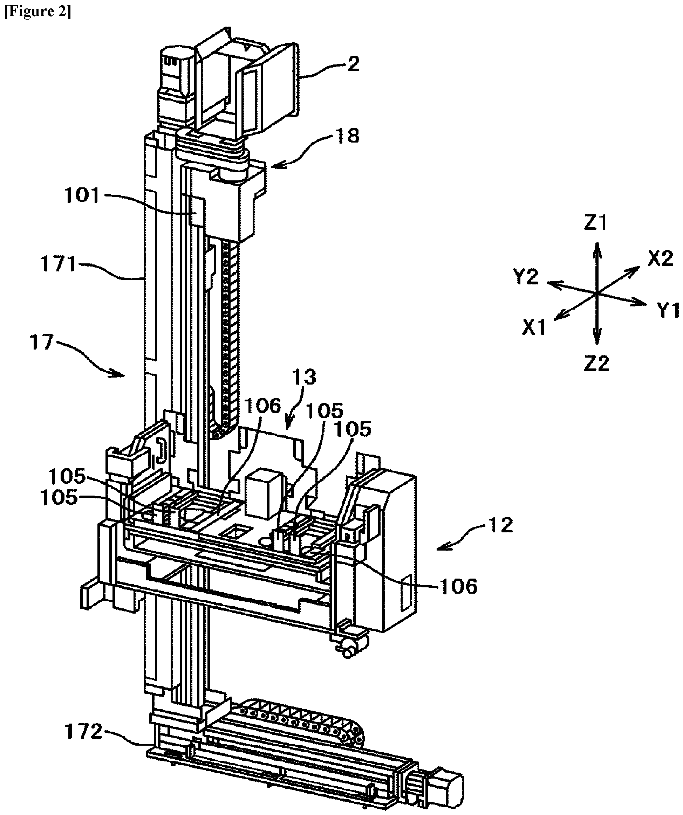

As shown in FIG. 2, the cassette transfer robot 17 includes a CZ drive shaft 171 serving as a third shaft and a CS drive shaft 172 serving as a second shaft. The CZ drive shaft 171 is configured to move the robot arm 18 serving as a first shaft in the up-down direction (that is, in the Z1-Z2 direction), and the CS drive shaft 172 is configured to move the CZ drive shaft 171 in the left-right direction (that is, in the Y2-Y1 direction). In other words, the robot arm 18 serves as a movable structure configured to be movable horizontally and movable up and down. Thereby, the robot arm 18 is capable of accessing the cassette 2 at an appropriate position.

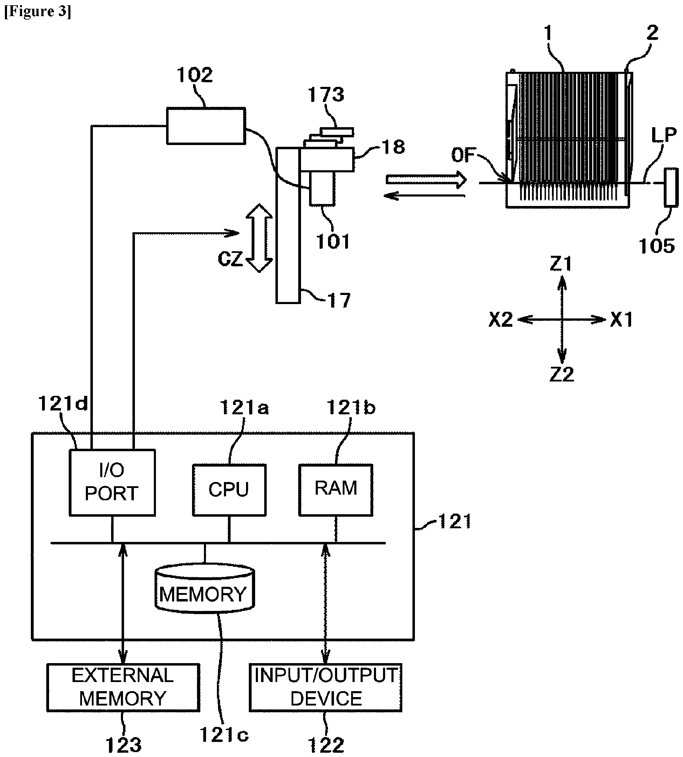

As shown in FIGS. 2 and 3, a reflective optical sensor 101 is provided at a base of the robot arm 18, for example, at a lower end of the robot arm 18. In other words, the reflective optical sensor 101 is provided at the movable structure of the cassette transfer robot 17. The reflective optical sensor 101 is not capable of being driven by the robot arm 18. Therefore, the reflective optical sensor 101 is configured to be movable horizontally and movable up and down.

As shown in FIGS. 2 and 3, two reflectors (that is, a pair of reflectors) 105 are provided for each of the cassettes 2. The two reflectors 105 are provided at the cassette stage device 13 opposite to the reflective optical sensor 101 with the cassette 2 related thereto provided therebetween. In other words, the cassette stage device 13 is provided with four reflectors (that is, two pairs of reflectors) 105 corresponding to the two cassettes 2. Hereinafter, each of the reflectors 105 may also be referred to as a "reflector 105". An opening on a bottom of the cassette 2 placed on the cassette stage device 13 is located at a location where the reflective optical sensor 101 and the reflector 105 face each other. As shown in FIG. 3, the reflective optical sensor 101 is provided with a predetermined distance from the cassette 2. Further, the wafer 1 stored in the cassette 2 placed on the cassette stage device 13 is in a vertical state. Further, as shown in FIG. 2, a plurality of reflectors 106 extending in the X1-X2 direction beside a plurality of wafer alignment holes 53 described later, respectively, are provided at the cassette stage device 13. Hereinafter, each of the reflectors 106 may also be referred to as a "reflector 106", and each of the wafer alignment holes 53 may also be referred to as a "wafer alignment hole 53".

While the present embodiments are described by way of an example in which the reflector 105 is provided at the cassette stage device 13, the present embodiments are not limited thereto. When the cassette 2 is inserted (loaded) into the cassette stage device 13 from a front of the apparatus instead of being inserted into the cassette stage device 13 from above, and when the reflector 105 interferes with an insertion of the cassette 2, for example, the reflector 105 may be provided at a movable shutter of a cassette insertion port on a front panel of the apparatus.

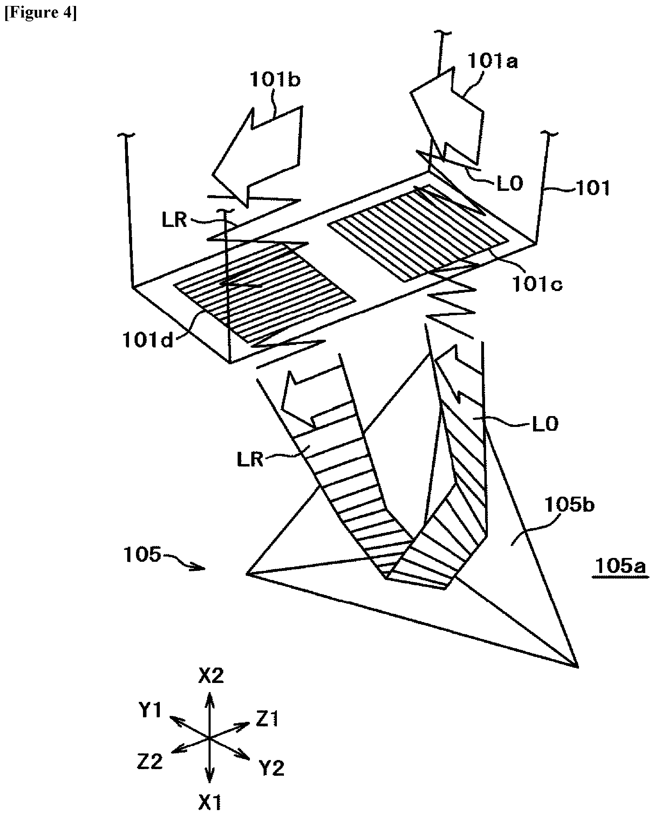

The reflective optical sensor 101 and the reflector 105 will be described with reference to FIG. 4. The reflective optical sensor 101 includes: a light emitter (which is a light emitting structure) 101a configured to emit an outgoing light LO toward the wafer 1 accommodated in the cassette 2; and a light receiver (which is a light receiving structure) 101b configured to receive a reflected light LR obtained by reflecting the outgoing light LO on the reflector 105. In the reflective optical sensor 101, for example, the light emitter 101a and the light receiver 101b are arranged adjacent to each other and are integrated. The reflective optical sensor 101 is configured as a so-called reflective photoelectric sensor.

The reflective optical sensor 101 includes a polarizing filter 101c provided corresponding to the light emitter 101a and a polarizing filter 101d provided corresponding to the light receiver 101b. Polarization directions of the polarizing filter 101c and the polarizing filter 101d are set to be different from each other. That is, according to the present embodiments, the polarization directions may be orthogonal to each other.

By passing through the polarizing filter 101c, the outgoing light LO becomes a linearly polarized light (for example, a wave in the Y1-Y2 direction) vibrating in a direction (first direction), and also becomes a beam-shaped parallel light directed toward the reflector 105. Thereafter, the outgoing light LO is returned and reflected back by the reflector 105 and directed toward the light receiver 101b as the reflected light LR. The reflected light LR is a linearly polarized light (for example, a wave in the Z1-Z2 direction) vibrating in a direction (second direction) orthogonal to the outgoing light LO, and can pass through the polarizing filter 101d. In other words, the polarizing filter 101d is a polarizing filter whose absorption axis is in the first direction. Further, the reflective optical sensor 101 is capable of accurately determining (detecting) whether the orientation flats of the wafers 1 are aligned based on a presence or absence of the reflected light LR.

For example, the reflector 105 is further configured to return and reflect a light whose polarization direction is different from a polarization direction of the incident light incident on the reflector 105 (that is, the outgoing light LO) as the reflected light LR to the light receiver 101b. For example, a reflective surface 105a of the reflector 105 is constituted by a plurality of corner cubes 105b which are regularly arranged. Hereinafter, each of the plurality of corner cubes 105b may also be referred to as a "corner cube 105b". The term "corner cube" may refer to a minute hollow whose shape is formed by combining three planes orthogonal to one another, for example. Thereby, the reflector 105 is configured to be capable of returning and reflecting the light. Further, in FIG. 4, a representative enlarged view of the corner cube 105b is illustrated. Further, the reflector 105 may include a transparent particle substance. The reflector 105 is not limited to the corner cube 105b described above. For example, the reflector 105 may be of any structure capable of rotating the polarization direction of the incident light to a greater extent than the reflected light reflected by the wafer 1.

The reflector 105 is provided at one end (that is, a first end) of a predetermined optical path LP. The predetermined optical path LP is set such that the outgoing light LO from the reflective optical sensor 101 can pass therethrough without hitting the wafer 1 when each of the orientation flats of the wafers 1 is oriented in a predetermined direction (that is, when each of the orientation flats of the wafers 1 is aligned at a predetermined location). The optical path LP is perpendicular to the surface of the wafer 1, and a plurality of optical paths including the optical path LP are set for the cassette 2 on the cassette stage device 13. Hereinafter, the plurality of optical paths including the optical path LP may also be referred to as "optical paths LP". According to the present embodiments, two optical paths LP are set in a manner corresponding to the vicinity of both ends of the orientation flat of the wafer 1 aligned in the predetermined direction within the cassette 2. However, three or more optical paths LP may be provided. A controller 121 serving as a control structure is configured to be capable of checking whether or not the orientation flats of the wafers 1 are aligned (or oriented) in the predetermined direction by sequentially moving the reflective optical sensor 101 to a plurality of positions corresponding to the optical paths LP. In other words, the controller 121 is configured to be capable of causing the reflective optical sensor 101 to move to the other end (that is, a second end) of the optical path LP set for the cassette 2 (which is a target to be checked) such that the reflective optical sensor 101 is commonly used for the cassettes 2.

When the orientation flats of an entirety of the wafers 1 are aligned, in the two optical paths LP, the outgoing light LO from the light emitter 101a hits the reflector 105, and the reflected light LR returns to the light receiver 101b. On the other hand, when one or more of the orientation flats of the wafers 1 are not aligned (when the orientation flats are not horizontal), the outgoing light LO from the light emitter 101a is blocked by the wafers 1 in one of the optical paths LP. Therefore, the outgoing light LO does not reach the reflector 105, and the reflected light LR does not return to the light receiver 101b. Further, in such a case, the outgoing light LO is reflected by the wafers 1 and the outgoing light LO reflected by the wafers 1 returns to the light receiver 101b. However, the outgoing light LO reflected by the wafers 1 cannot pass through the polarizing filter 101d. Therefore, the outgoing light LO reflected by the wafers 1 cannot be detected by the light receiver 101b. Further, when the wafer 1 whose light transmittance is similar to that of silicon carbide (SiC) is located in the optical path LP, it is detected as a decrease in a light reception level of the light receiver 101b. In the reflective optical sensor 101, an attenuation of the light reception level due to the wafer 1 with the light transmittance is twice that of a transmissive optical sensor. Thereby, it is possible to preferably increase a detection accuracy of the reflective optical sensor 101 as compared with that of the transmissive optical sensor.

While the present embodiments are described by way of an example in which the wafer 1 is provided with the orientation flat, the present embodiments are not limited thereto. For example, even when the wafer 1 is provided with a notch obtained by cutting out a part of a circumference of the wafer 1 in a V shape, it is possible to similarly check whether or not the notch of the wafer 1 is aligned. In such a case, the optical path LP is set for each of the cassettes 2 on the cassette stage device 13. The reflector 105 is provided for each of the cassettes 2. The reflector 105 is provided at the cassette stage device 13 opposite to the reflective optical sensor 101 with the cassette 2 related thereto provided therebetween. In other words, the cassette stage device 13 is provided with two reflectors 105 in a manner corresponding to the two cassettes 2.

The controller 121 is configured to be capable of controlling the cassette transfer robot 17 such that the reflective optical sensor 101 is moved to a detection position of the orientation flat or the notch corresponding to a parameter such as a size and a material of the wafer 1. Further, before moving the reflective optical sensor 101, the reflective optical sensor 101 is at a position (which is a home position) shown in FIG. 2. After it is confirmed that the orientation flats of the wafers 1 are aligned, the reflective optical sensor 101 returns to the home position. On the other hand, since a size of the reflector 105 is set such that the reflector 105 is capable of reflecting the outgoing light LO on the optical path LP for the entire types of the wafers 1 to be handled, it is preferable that the reflector 105 is not moved.

As shown in FIG. 3, an output (current value) of the reflective optical sensor 101 is input to the controller 121 via an amplifier 102. The amplifier 102 performs a threshold value determination. For example, the threshold value is set to a value between a light reception level when the orientation flats of an entirety of silicon carbide (SiC) wafers are aligned and a light reception level when an orientation flat of a single wafer such as a silicon carbide wafer (SiC wafer) whose light transmittance is the highest among wafers to be handled is not aligned. In the present specification, the term "when the orientation flat of a single wafer whose light transmittance is the highest is not aligned" may refer to a case where the wafer blocks one or both of the optical paths of the reflective optical sensor 101 through which the light is emitted or received.

In addition to or instead of the above-mentioned example of an absolute value determination using a fixed optical path, during confirming the orientation flat the reflective optical sensor 101 may be moved along the orientation flat in the Y2-Y1 direction or across the edge in the Z1-Z2 direction to determine based on a change in an intensity (that is, a relative value determination may be performed). Further, since the light is scattered at the edge of the wafer, it is possible to obtain a large change in the light reception level even with a wafer whose light transmittance is close to 100 %.

The controller 121 will be described with reference to FIG. 3. The controller 121 may be constituted by a computer including a CPU (Central Processing Unit) 121a, a RAM (Random Access Memory) 121b, a memory 121c and an I/O port 121d. The RAM 121b, the memory 121c and the I/O port 121d may exchange data with the CPU 121a through an internal bus 121e. For example, an input/output device 122 constituted by a component such as a touch panel and an external memory 123 are connected to the controller 121.

For example, the memory 121c is configured by a component such as a flash memory and an HDD (Hard Disk Drive). For example, a control program configured to control operations of the substrate processing apparatus 10 and a process recipe (hereinafter, also simply referred to as a "recipe") containing information on sequences and conditions of a substrate processing described later may be readably stored in the memory 121c. The recipe is obtained by combining steps of the substrate processing described later such that the controller 121 can execute the steps to acquire a predetermined result, and is a high-level language compared to the control program. Hereinafter, the control program and the recipe may be collectively or individually referred to as a "program". For example, the memory 121c is configured to sequentially store log information regarding the operations and states of the apparatus. The RAM 121b functions as a memory area (work area) where a program or data read by the CPU 121a is temporarily stored.

The I/O port 121d is connected to the above-described components such as the cassette transfer structure 12, the cassette stage device 13, the wafer posture aligner 14, the cassette transfer robot 17, the wafer transfer device 19, a rotator (not shown), the boat elevator 22 and the amplifier 102.

The CPU 121a is configured to read the control program from the memory 121c and execute the read control program. Furthermore, the CPU 121a is configured to read the recipe of the substrate from the memory 121c in accordance with an operation command inputted from the input/output device 122. In accordance with the contents of the read recipe, the CPU 121a may be configured to control various operations such as a posture alignment operation of the cassette transfer structure 12, a rotation operation of the cassette stage device 13, an operation of the wafer posture aligner 14, a control operation of the robot arm 18 by the cassette transfer robot 17, a rotation control operation and an elevating and lowering control operation of the wafer transfer device 19, and an elevating and lowering control operation of the boat elevator 22.

The controller 121 may be embodied by installing the above-described program stored in the external memory 123 into the computer. For example, the external memory 123 may include a magnetic disk such as a hard disk and a semiconductor memory such as a USB memory. The memory 121c or the external memory 123 may be embodied by a tangible (non-transitory) computer readable recording medium.

Hereafter, the memory 121c and the external memory 123 may be collectively or individually referred to as a "recording medium". In the present specification, the term "recording medium" may refer to the memory 121c alone, may refer to the external memory 123 alone, and may refer to both of the memory 121c and the external memory 123. Instead of the external memory 123, a communication structure such as the Internet and a dedicated line may be used for providing the program to the computer.

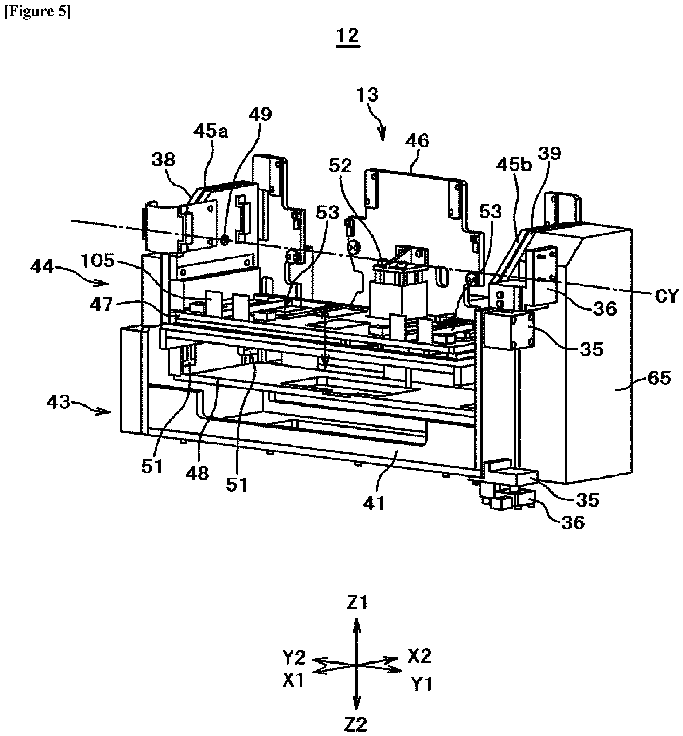

The cassette transfer structure 12 will be described with reference to FIG. 5.

A frame 43 is constituted by fixing a front plate 41 in the X1 direction and a rear plate (not shown) in the X2 direction to a lower portion of a left side plate 38 in a Y2 direction and a right side plate 39 in a Y1 direction. A lower portion of the frame 43 is of a rectangular tube shape.

Two hinge structures 35 are vertically fixed to an outer surface of the right side plate 39 at an end of the right side plate 39 adjacent to the front plate 41. Two hinge structures 36 are fixed to a front portion (in the X1 direction) of the housing 11 shown in FIG. 1, and are connected to the two hinge structures 35 corresponding thereto. Hereinafter, each of the two hinge structures 35 may also be referred to as a "hinge structure 35", and each of the two hinge structures 36 may also be referred to as a "hinge structure 36". By the hinge structure 35 which is rotatable around an axis in the Z1-Z2 direction, the cassette stage device 13 is rotatably supported with respect to the housing 11.

A rotating shaft 49 is configured to support the placement table 44 on the left side plate 38 and the right side plate 39 so as to be rotatable around a CY axis. The placement table 44 includes a pair of rotating plates 45a and 45b, an internal transfer stage 46, an external transfer stage 47 and a lower plate 48. Each of the rotating plates 45a and 45b is fixed to the rotating shaft 49 on the CY axis, and is rigidly joined by the lower plate 48 provided between the rotating plates 45a and 45b. The placement table 44 is configured to be rotatable around the rotating shaft 49. The internal transfer stage 46 is fixed to the rotating plates 45a and 45b and/or the lower plate 48. The external transfer stage 47 is attached to the rotating plates 45a and 45b in a horizontal state via a plurality of guides 51 (which is configured to allow a movement in one direction alone) such that the cassette 2 in the vertical posture is movable up and down. An air cylinder 52 is provided between the internal transfer stage 46 and the external transfer stage 47, and is configured to drive the external transfer stage 47 up and down. In other words, the cassette stage device 13 includes a vertical mover. The external transfer stage 47 is further configured to be movable in the front-rear direction (X1-X2 direction). The two cassettes 2 can be placed on the internal transfer stage 46 or the external transfer stage 47. In other words, each of the internal transfer stage 46 and the external transfer stage 47 is provided with two stages.

For example, two wafer alignment holes 53 are provided in the external transfer stage 47 with a predetermined interval therebetween. The wafer posture aligner 14 is provided at the lower plate 48 below the wafer alignment holes 53.

A drive structure 65 configured to rotate the rotating shaft 49 is provided at the outer surface of the right side plate 39. For example, the drive structure 65 includes components such as an AC servo motor, a worm gear box and a position sensor, and is configured to be capable of rotating the cassette 2 on the placement table 44 by 90 ° between the horizontal posture and the vertical posture.

By the vertical mover of the cassette stage device 13, it is possible to move the external transfer stage 47 between an upper position and a lower position. When the external transfer stage 47 is at the upper position, the cassette 2 in the vertical posture (that is, in an upright state) can be rotated by the cassette posture converter. When the external transfer stage 47 is at the lower position, the cassette 2 in the vertical posture can be aligned by the orientation aligner (that is, the wafer posture aligner 14).

When the external transfer stage 47 is at the upper position, by moving the external transfer stage 47 in the front-rear direction, it is possible to press (or dock) the cassette 2 inserted thereto against the internal transfer stage 46 in the upright state or it is possible to separate (or undock) the cassette 2 from the internal transfer stage 46. Further, when the external transfer stage 47 is at the upper position, the optical path LP is arranged in a space provided between the cassette 2 and the wafer posture aligner 14. Thereby, it is possible to check the orientation flat.

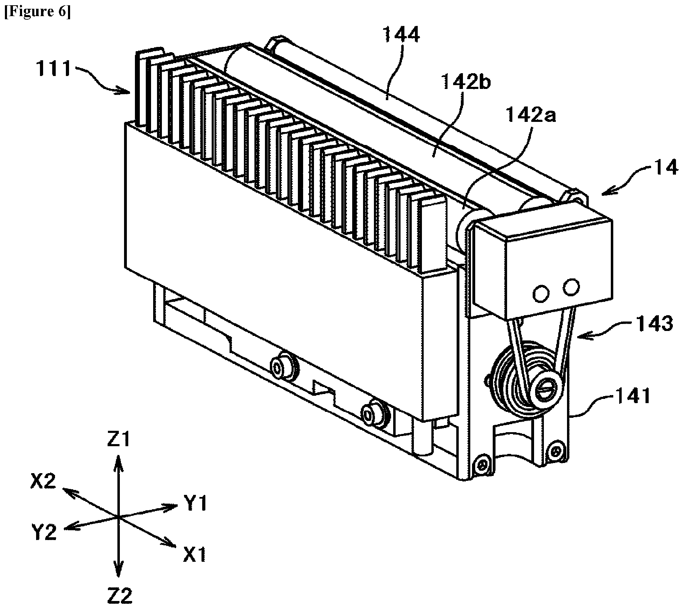

An example of the wafer posture aligner 14 will be described with reference to FIG. 6.

The wafer posture aligner 14 includes a support base 141, a pair of rollers 142a and 142b rotatably spanned over the support base 141 in the horizontal direction, a rotation driver (which is a rotation driving structure) 143 and a stopper 144 provided adjacent to the roller 142b. Each of the pair of rollers 142a and 142b extends in a direction in which the wafers stored in the cassette 2 are aligned (that is, in the X1-X2 direction). The rotation driver 143 is configured to synchronously rotate the rollers 142a and 142b in the same direction. The wafer posture aligner 14 is configured to be movable up and down relative to the cassette 2 placed on the placement table 44. During an alignment operation, by elevating the wafer posture aligner 14 such that the wafers 1 in the cassette 2 placed on the cassette stage device 13 are in contact with the rollers 142a and 142b and by rotating the wafers 1 in the same direction by the rollers 142a and 142b, the orientation flats between the wafers 1 can be aligned at a constant location. In other words, the orientation alignment is mechanically performed by rotating the rollers 142a and 142b such that the wafers 1 are rotated once or more and by regulating a rotation of the wafers 1 by the stopper 144 and idling the rollers 142a, 142b when the orientation flats are aligned. When the orientation alignment includes an up-and-down movement of the external transfer stage 47, it may take several minutes to perform the orientation alignment. A notch alignment may be performed in a similar manner.

For example, a comb-shaped sensor 111 is provided at the wafer posture aligner 14 so as not to mechanically interfere with the cassette 2 placed on the cassette stage device 13. The comb-shaped sensor 111 is made of a predetermined material and is configured to detect a presence or absence of the wafer 1 in the cassette 2 before a wafer posture alignment (when the wafer 1 is in the vertical state). The comb-shaped sensor 111 is attached to a side surface of the support base 141 adjacent to the roller 142a (in the Y2 direction) so as to be movable up and down relative to the cassette 2. The comb-shaped sensor 111 is configured to be movable between a detection position and a retracted position so as to be capable of detecting wafers of any size included in detection parameters described later. Thereby, it is possible to commonly use the comb-shaped sensor 111 for the wafers with different diameters, and it is also possible to improve the versatility. A wafer mapping by the comb-shaped sensor 111 is performed in a posture different from that of the cassette 2 in a wafer mapping by the reflective optical sensor 101, which will be described later. That is, it is possible to provide the comb-shaped sensor 111 at a different position from that of the reflective optical sensor 101.

The comb-shaped sensor 111 is configured as a comb-shaped structure in which a plurality of sensor pairs each including a light emitter and a light receiver are arranged in a number corresponding to the number of the wafers 1 capable of being accommodated in the cassette 2 along an arrangement direction of the wafers 1. A light emitting surface of the light emitter of each sensor pair (in which the light emitting surface and a light receiving surface of the light receiver face each other) is positioned such that the presence or absence of each wafer 1 can be detected by each sensor pair. For example, the light emitter of each sensor pair is constituted by a light emitting diode, and the light receiver of each sensor pair is constituted by a phototransistor.

The light emitter of each sensor pair is arranged in a manner corresponding to a side portion of an arrangement area (arrangement region) of the wafer 1, in the present example, corresponding to a side portion of a storage area (slot) for each of the wafers 1 in the cassette 2. The light receiver of each sensor pair is arranged on an incident optical path of the light from the light emitter so as to face the light emitter via the storage area for each of the wafer 1. When the comb-shaped sensor 111 is elevated, the light emitter and the light receiver are arranged such that the light emitting surface of the light emitter faces a first surface of the wafer 1 and the light receiving surface of the light receiver faces a second surface of the wafer 1 opposite to the first surface.

The comb-shaped sensor 111 is configured as a transmission type sensor configured to irradiate the wafer 1 with a reference light and configured to detect the light passing through the wafer 1. In a case where the wafer 1 is configured as a non-transparent wafer (for example, a silicon wafer), the light receiver of each sensor pair receives (detects) the light (that is, the reference light) emitted from the light emitter of each sensor pair when the wafer 1 is not present, and the light receiver of each sensor pair does not receive (detect) the light (that is, the reference light) emitted from the light emitter of each sensor pair when the wafer 1 is present. Thereby, it is possible to detect the presence or absence of the wafer 1. However, the presence or absence of the wafer 1 is actually determined by a threshold value processing (which is designed for the silicon wafer) of an amount of the light received by the light receiver of each sensor pair. In a case where the wafer 1 is configured as a transparent wafer (for example, a quartz wafer), since an amount of the light transmitted by the transparent wafer exceeds a threshold value, it is not possible to determine the presence or absence of the wafer 1. In addition, when the wafer 1 is configured as a wafer such as the SiC wafer whose light transmittance is about in the middle between that of the silicon wafer and that of the quartz wafer, it is not possible to guarantee a detection of the SiC wafer. Further, there is no space left in the opening on the bottom of the cassette 2 to accommodate a comb-shaped sensor designed for the SiC wafers.

### (2) Substrate Processing

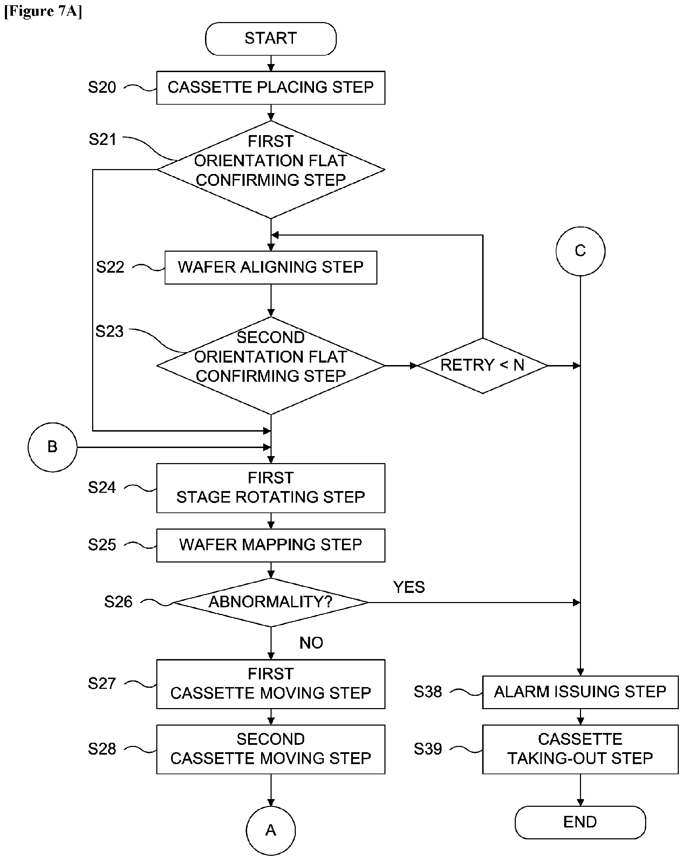

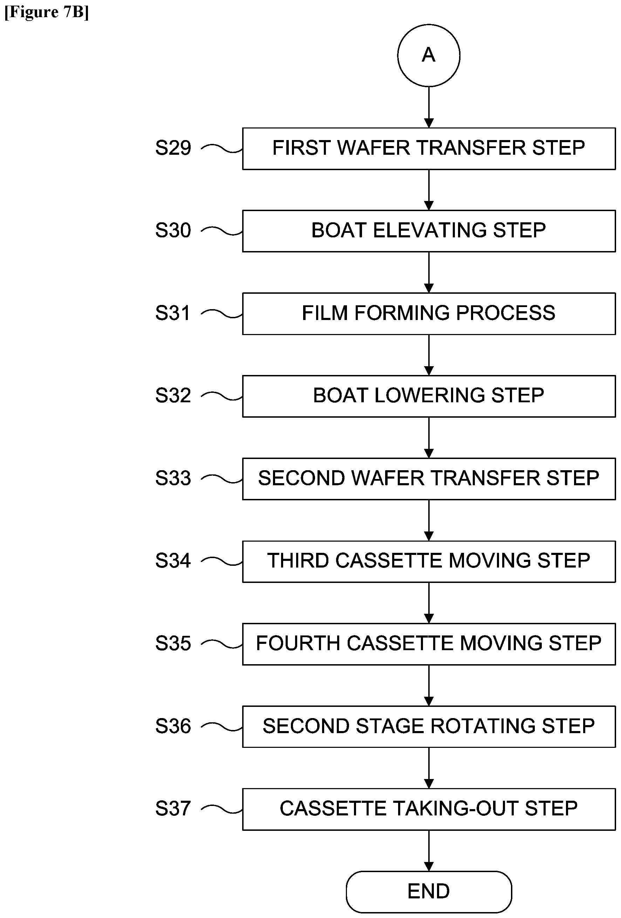

Subsequently, a substrate processing method using the reaction tube 31 of the processing apparatus 10 will be described with reference to FIGS. 7A and 7B. The substrate processing method mentioned above will be described by way of an example in which a step in a manufacturing process of a semiconductor device (for example, a film forming process in which a film is formed on the wafer 1) is performed by using the reaction tube 31 of the processing apparatus 10 described above. In the following description, the operations of components constituting the processing apparatus 10 are controlled by the controller 121.

### <Cassette Placing Step: S20>

The wafers (which is unprocessed) 1 are charged (loaded) into the cassette 2. Then, the cassette 2 is transferred to the front of the housing 11 by the external transfer device (not shown) and is placed on the cassette stage device 13 of the cassette transfer structure 12. The wafers 1 in the cassette 2 are in the vertical state. When the cassette 2 is placed on the cassette stage device 13, the external transfer stage 47 of the cassette stage device 13 is at the upper position.

### <First Orientation Flat Confirming Step: S21>

First, with the external transfer stage 47 at the home position (upper position), an orientation flat confirmation is performed using the reflective optical sensor 101. The orientation flat confirmation is performed by moving the reflective optical sensor 101 to positions corresponding to the two optical paths LP. When the orientation flats are not aligned, a wafer aligning step S22 is performed. When the orientation flats of the entirety of the wafers 1 are aligned, an orientation flat alignment (that is, the wafer aligning step S22) is skipped and a step S24 is performed.

### <Wafer Aligning Step: S22>

After the external transfer stage 47 is lowered to the lower position by the air cylinder 52, the wafers 1 are aligned by the wafer posture aligner 14 using the orientation flats.

### <Second Orientation Flat Confirming Step: S23>

After the external transfer stage 47 is elevated to the upper position, the orientation flat confirmation is performed by the reflective optical sensor 101, similarly to the step S21. When the orientation flats of the entirety of the wafers 1 are aligned, the step S24 is performed. When the orientation flats are not aligned, the step S22 is performed again, and a wafer alignment is retried. However, when the number of retries is equal to or greater than a predetermined number N, a step S38 is performed. Further, before performing the step S38, another retry may be performed by moving the optical path of the reflective optical sensor 101 slightly downward (by lowering an accuracy of the orientation flat alignment.

### <First Stage Rotating Step: S24>

Subsequently, by rotating the cassette stage device 13 by 90 °, the cassette 2 is rotated by 90 °. Thereby, the wafers 1 in the cassette 2 are in a horizontal state.

### <Wafer Mapping Step: S25>

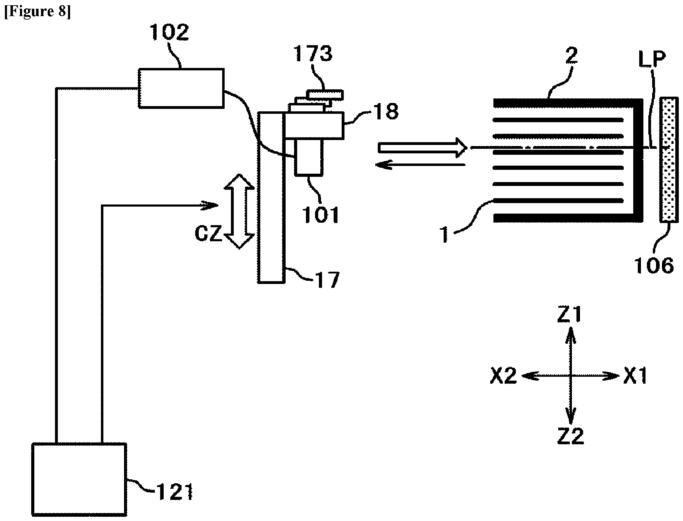

Subsequently, as shown in FIG. 8, when the wafers 1 are in the horizontal state in the cassette stage device 13, by operating the CZ drive shaft 171 and the CS drive shaft 172, the reflective optical sensor 101 is moved to a position behind the reflector 106 of the cassette stage device 13 (in the X2 direction). Then, by elevating the robot arm 18 using the CZ drive shaft 171, the reflective optical sensor 101 scans the cassette 2 from the bottom to the top (with a resolution of 0.05 mm). The reflector 106 is substantially the same structure as the reflector 105, and faces the opening on the bottom of the cassette 2 facing the external transfer stage 47. The reflector 106 is provided near the wafer alignment holes 53 of the external transfer stage 47 so as not to interfere with the operation of the wafer posture aligner 14. Thereby, it is possible to ensure the optical path between the reflective optical sensor 101 and the reflector 106.

Since the reflective optical sensor 101 receives a retroreflection from the reflector 106 (that is, the reflective optical sensor 101 receives the light LO returned and reflected back by the reflector 106), a received light intensity (amount of the light) is low at a location where the wafer 1 is present, and the received light intensity is high at a location where the wafer 1 is not present. Such a received light intensity is acquired as scan data. Further, since a slot width of the cassette 2 is greater than a thickness of the wafer 1, there are locations where the wafer 1 is not present even within the slot. By performing a threshold value processing to the scan data, and sections in which the scan data is continuously below a threshold value are extracted as detection data. The detection data corresponds to the thickness of the wafer 1. The threshold value (for mapping) used in the present step is common to any combinations of sizes and materials of the substrates (wafers), and may be substantially the same as the threshold value for the orientation flat confirmation.

The presence ("ON") and absence ("OFF") of the wafer 1 and an abnormality of the wafer 1 in each slot are determined based on the detection data for each slot. When there is no detection data or when the position or the thickness in the Z1-Z2 direction does not fall within a tolerance range, it is determined that the slot is abnormal.

### <Abnormality Determination Step: S26>

When it is determined in the step S25 that there is an abnormality, the step S38 is performed. When it is determined in the step S25 that there is no abnormality, a step S27 is performed.

### <First Cassette Moving Step: S27>

Subsequently, the cassette 2 is held (supported) by the hand 173 of the robot arm 18, and the cassette 2 is transferred to the cassette shelf 15 or the spare cassette shelf 16 by the hand 173 of the robot arm 18.

### <Second Cassette Moving Step: S28>

Subsequently, the cassette 2 is transferred by the hand 173 of the robot arm 18 from the cassette shelf 15 or the spare cassette shelf 16 to a transfer shelf located at a position facing the wafer transfer device 19 of the cassette shelf 15. Then, a step S29 in FIG. 7B is performed.

### <First Wafer Transfer Step: S29>

The wafers 1 in the cassette 2 are in the horizontal state, and the wafers 1 in the cassette 2 placed on the transfer shelf are transferred and loaded into the boat 25 by the wafer transfer device 19.

### <Boat Elevating Step: S30>

Subsequently, the boat 25 is loaded into the reaction tube 31 by the boat elevator 22.

### <Film Forming Process: S31>

After the boat 25 is loaded into the reaction tube 31, an inner atmosphere of the process chamber 32 is controlled such that an inner pressure of the process chamber 32 reaches and is maintained at a predetermined pressure. Further, an inside of the process chamber 32 is controlled such that an inner temperature of the process chamber 32 reaches and is maintained at predetermined temperature using a heater. For example, a source gas and a reactive gas are supplied into the process chamber 32 to form the film on the wafer 1.

### <Boat Lowering Step: S32>

After the film forming process is performed, the boat 25 is taken out from the reaction tube 31 by the boat elevator 22 (that is, the boat 25 is unloaded).

### <Second Wafer Transfer Step: S33>

Subsequently, the wafers 1 (which are processed) in the boat 25 are transferred into the cassette 2 on the transfer shelf by the wafer transfer device 19.

### <Third Cassette Moving Step: S34>

Subsequently, the cassette 2 on the transfer shelf is transferred to the cassette shelf 15 or the spare cassette shelf 16 by the hand 173 of the robot arm 18.

### <Fourth Cassette Moving Step: S35>

When the cassette 2 is transferred (unloaded) out of the processing apparatus 10, the cassette 2 is transferred from the cassette shelf 15 or the spare cassette shelf 16 to the cassette stage device 13 of the cassette transfer structure 12 using the hand 173 of the robot arm 18.

### <Second Stage Rotating Step: S36>

Subsequently, the cassette 2 is rotated by 90 ° by the cassette stage device 13, an access port of the cassette 2 is rotated to an upward posture, and the wafers 1 are in the vertical state.

### <Cassette Taking-out Step: S37>

Thereafter, the cassette 2 is taken out and transferred outside the housing 11 by the external transfer device.

### <Alarm Issuing Step: S38)

When it is determined in the steps S23 and S26 that there is an abnormality, an alarm is issued.

### <Cassette Taking-out Step: S39>

When the alarm is canceled, the cassette 2 is manually taken out from the cassette stage device 13.

According to the present embodiments, it is possible to obtain one or more of the effects described below.
(a) Since the reflective optical sensor 101 can be moved to the position corresponding to the optical path, it is possible to perform a detection of the wafer 1 with respect to a plurality of optical paths by using one sensor (that is, the reflective optical sensor 101 alone).
(b) Since the reflective optical sensor 101 can be moved to the position corresponding to the optical path, it is possible to perform the orientation flat confirmation for the wafers stored in the plurality of cassettes 2 by using one sensor (that is, the reflective optical sensor 101 alone).
(c) Since the position of the optical path can be changed depending on a type of the wafers by moving the reflective optical sensor 101, even when dimensions such as the orientation flat of each wafer are different depending on a diameter and material of each wafer, it is possible to perform the detection by using one sensor (that is, the reflective optical sensor 101 alone) by moving the reflective optical sensor 101.
(d) Since the position of the optical path can be changed by moving the reflective optical sensor 101, it is possible to appropriately set a recall rate and a precision rate of detecting the orientation flat, and it is also possible to perform the detection with a higher accuracy.
(e) Since the orientation flat confirmation is performed before the orientation flat alignment, when the orientation flats are aligned, it is possible to skip the orientation flat alignment. Thereby, it is possible to shorten a cassette placing time (cassette loading time).
(f) Since the detection can be performed with a higher accuracy and an orientation flat position accuracy can be ensured, it is possible to improve a reliability of transferring the wafer.
(g) Since the reflective optical sensor 101 and the reflector 105 are used to confirm the orientation flat, it is possible to perform the detection wherever the orientation indicator is visible from the outside.
(h) Since the reflective optical sensor 101 and the reflector 105 are used to confirm the orientation flat, it is possible to simplify the wiring as compared with that of the transmission type sensor, and it is also possible to easily install the reflective optical sensor 101 and the reflector 105 to an existing apparatus.

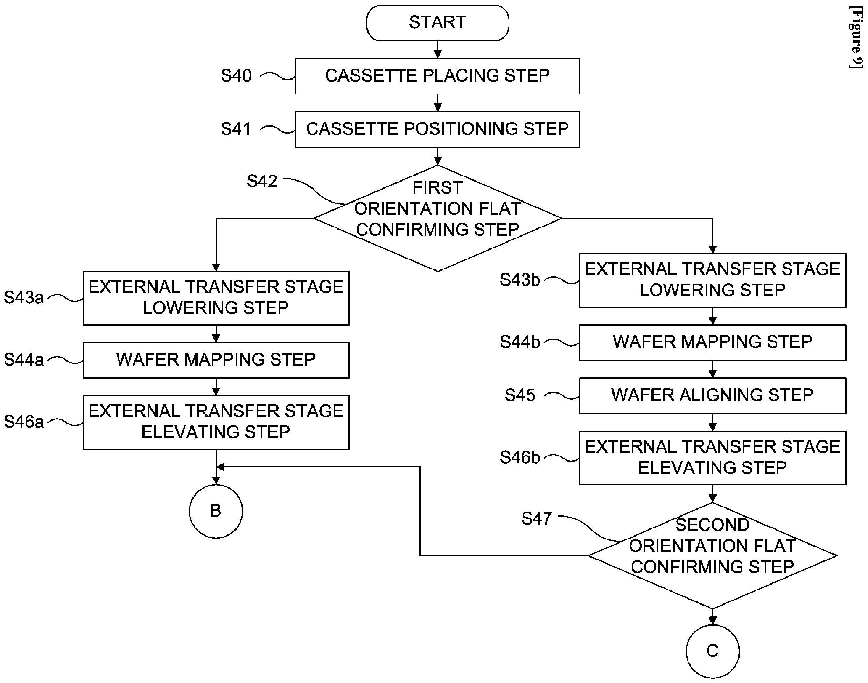

A modified example of the substrate processing step of the processing apparatus will be described with reference to FIG. 9.

### <Cassette Placing Step: S40>

Similar to the step S20 in the embodiments described above, the wafers (which is unprocessed) 1 are charged (loaded) into the cassette 2. Then, the cassette 2 is transferred to the front of the housing 11 by the external transfer device (not shown) and is placed on the cassette stage device 13 of the cassette transfer structure 12. The wafers 1 in the cassette 2 are in the vertical state. When the cassette 2 is placed on the cassette stage device 13, the external transfer stage 47 of the cassette stage device 13 is at the home position.

### <Cassette Positioning Step: S41>

The external transfer stage 47 moves backward (in the X2 direction) to press (dock) the cassette 2 placed on the cassette stage device 13 against the internal transfer stage 46 in the upright state so as to position the cassette 2.

### <First Orientation Flat Confirming Step: S42>

The orientation flats of the wafers 1 stored in the cassette 2 is confirmed by the reflective optical sensor 101. When the orientation flats of the entirety of the wafers 1 are aligned, a step S43a is performed. When the orientation flats are not aligned, a step S43b is performed.

### <External Transfer Stage Lowering Step: S43a>

The external transfer stage 47 is lowered to the lower position.

### <Wafer Mapping Step: S44a>

The wafer mapping is performed by using the comb-shaped sensor 111 to detect the presence or absence of the wafer 1 in the cassette 2 for each slot.

### <External Transfer Stage Elevating Step: S46a>

The external transfer stage 47 is elevated to the home position. Then, the step S24 (shown in FIG. 7A) of the embodiments described above is performed.

For example, when it is determined to be "ON" in the step S25 (that is, the wafer mapping by the reflective optical sensor 101) following the step S24, and when it is determined to be "ON" in the wafer mapping by the comb-shaped sensor 111, the material of the wafer 1 is determined to be silicon (Si). Further, when it is determined to be "ON" in the wafer mapping by the reflective optical sensor 101 and when it is determined to be "OFF" in the wafer mapping by the comb-shaped sensor 111, the material of the wafer 1 is determined to be silicon carbide (SiC). Further, when it is determined to be "OFF" in the wafer mapping by the reflective optical sensor 101 and when it is determined to be "OFF" in the wafer mapping by the comb-shaped sensor 111, it is determined that the wafer 1 is not present.

### <External Transfer Stage Lowering Step: S43b>

Similar to the step S43a, the external transfer stage 47 is lowered to the lower position.

### <Wafer Mapping Step: S44b>

Similar to the step S44a, the wafer mapping is performed by using the comb-shaped sensor 111.

### <Wafer Aligning Step: S45>

Similar to the step S22, the wafers 1 are aligned by the wafer posture aligner 14 using the orientation flats.

### <External Transfer Stage Elevating Step: S46b>

Similar to the step S46a, the external transfer stage 47 is elevated to the home position.

### <Second Orientation Flat Confirming Step: S47>

The orientation flat confirmation is performed using the reflective optical sensor 101. When the orientation flats of the entirety of the wafers 1 are aligned, the step S24 (shown in FIG. 7A) of the embodiments described above is performed. When the orientation flats are not aligned, the step S38 (shown in FIG. 7A) of the embodiments described above is performed. Further, in the wafer mapping of the step S25, the material of the wafer 1 may be determined by integrating detection results of the comb-shaped sensor 111 in the step S44a or the step S44b. That is, when the wafer 1 is detected by both of the comb-shaped sensor 111 and the reflective optical sensor 101, it is possible to determine that the wafer 1 is a non-transparent wafer such as the silicon wafer, and when the wafer 1 is detected by the reflective optical sensor 101 alone, it is possible to determine that the wafer 1 is a transparent wafer such as the SiC wafer.

For example, the embodiments and the modified example mentioned above are described by way of an example in which a batch type substrate processing apparatus capable of simultaneously processing a plurality of substrates is used to form the film. However, the technique of the present disclosure is not limited thereto. For example, the technique of the present disclosure may be preferably applied when a single wafer type substrate processing apparatus capable of simultaneously processing one or several substrates is used to form the film. For example, the embodiments and the modified example mentioned above are described by way of an example in which a substrate processing apparatus including a hot wall type process furnace is used to form the film. However, the technique of the present disclosure is not limited thereto. For example, the technique of the present disclosure may be preferably applied when a substrate processing apparatus including a cold wall type process furnace is used to form the film.

The invention may be summarized as follows: To improve an accuracy of detecting whether an orientation of a substrate is correct, there is provided a technique that includes: a stage where a cassette accommodating substrates is placed, wherein the substrates are provided with orientation indicators; a reflector provided at a first end of an optical path set to enable a light to pass therethrough without hitting the substrates when the orientation indicators of the substrates are oriented in a predetermined direction; a robot configured to transfer the cassette between the stage and a shelf, and including a reflective optical sensor configured to emit the light along the optical path and to detect the light reflected from the reflector; and a controller controlling the robot to move the reflective optical sensor to a position corresponding to the optical path when checking whether the orientation indicators of the substrates on the stage are aligned in the predetermined direction.

Process procedures and process conditions of each process using the substrate processing apparatuses exemplified above may be substantially the same as those of the embodiments described above. Even in such a case, it is possible to obtain substantially the same effects as in the embodiments described above.

**[Description of Reference Numerals]**

| | | | |
|---|---|---|---|
| 1: | wafer (substrate) | 2: | cassette |
| 13: | cassette stage device | 15: | cassette shelf |
| 17: | cassette transfer structure | 18: | robot arm (movable structure) |
| 101: | reflective optical sensor | 105: | reflector |
| 121: | controller (control structure) | | |

## Claims

1. A substrate cassette handling apparatus comprising:
a stage on which a cassette accommodating a plurality of substrates is placed, wherein the plurality of substrates are provided with orientation indicators, respectively;
a reflector provided at a first end of a predetermined optical path, wherein the predetermined optical path is set so as to enable a light to pass therethrough without hitting the plurality of substrates when each of the orientation indicators of the plurality of substrates is oriented in a predetermined direction;
a robot configured to transfer the cassette between the stage and a shelf provided in the substrate cassette handling apparatus, and comprising a reflective optical sensor configured to emit the light along the optical path and to detect the light reflected from the reflector; and
a controller configured to be capable of controlling the robot to move the reflective optical sensor to a position corresponding to the optical path when checking whether or not the orientation indicators of the plurality of substrates on the stage are aligned in the predetermined direction.

2. The substrate cassette handling apparatus of claim 1, further comprising
one or more stages,
wherein each of the stage and the one or more stages is configured to be capable of delivering the cassette to and from an outside of the substrate cassette handling apparatus and one or more pairs of optical paths are set for each of the stage and the one or more stages, and
wherein the controller is further configured to be capable of causing the reflective optical sensor to move to a second end of the optical path set on a target stage to be confirmed among the stage and the one or more stages such that the reflective optical sensor is commonly used for the stage and the one or more stages.

3. The substrate cassette handling apparatus of claim 1 and/or 2, wherein the controller is further configured to be capable of changing a position of the optical path depending on a type of the plurality of substrates.

4. The substrate cassette handling apparatus of any one or more of claims 1 to 3, wherein the stage comprises:
a cassette posture converter configured to move the cassette between a first posture in which the plurality of substrates are stored in a horizontal arrangement and a second posture in which the plurality of substrates are stored in a vertical arrangement; and
an orientation aligner configured to rotate one or more substrates among the plurality of substrates in the first posture within the cassette to align the orientation indicators of the plurality of substrates.

5. The substrate cassette handling apparatus of claim 4, wherein the robot is further configured to take up the cassette in the second posture from thereunder and to transfer the cassette.

6. The substrate cassette handling apparatus of any one or more of claims 1 to 5, wherein the robot comprises:
a hand configured to handle the cassette;
a first shaft configured to move the hand in a front-rear direction of the substrate cassette handling apparatus;
a second shaft configured to move the hand in a left-and-right direction of the substrate cassette handling apparatus; and
a third shaft configured to move the hand in a vertical direction of the substrate cassette handling apparatus, and
wherein the reflective optical sensor is provided in a movable structure of the robot, and wherein the movable structure is capable of being driven by the second shaft and the third shaft and is not capable of being driven by the first shaft.

7. The substrate cassette handling apparatus of any one or more of claims 1 to 6, wherein the optical path is perpendicular to surfaces of the plurality of substrates, and a plurality of optical paths comprising the optical path are set for the cassette on the stage, and
wherein the controller is further configured to be capable of checking whether the orientation indicators of the plurality of substrates are oriented in the predetermined direction by moving the reflective optical sensor to a plurality of positions corresponding to the plurality of optical paths.

8. The substrate cassette handling apparatus of any one or more of claims 1 to 7, wherein the reflector is configured as a corner cube, or configured such that the light reflected from the reflector is polarized by substantially 90 ° with respect to the light incident to the reflector.

9. The substrate cassette handling apparatus of any one or more of claims 1 to 8, wherein the reflective optical sensor is further configured to emit the light polarized in a first direction and further configured to sense the light reflected from the reflector through a polarizing filter whose absorption axis is in the first direction.

10. The substrate cassette handling apparatus of any one or more of claims 1 to 9, wherein the controller is further configured to be capable of skipping an orientation flat alignment when it is confirmed that orientation flats of the plurality of substrates are oriented in the predetermined direction by sensing the light reflected from the reflector.

11. The substrate cassette handling apparatus of any one or more of claims 1 to 10, wherein the stage comprises:
a cassette posture converter configured to rotate the cassette between a first posture in which the plurality of substrates are stored in a horizontal arrangement and a second posture in which the plurality of substrates are stored in a vertical arrangement;
an orientation aligner configured to rotate a substrate among the plurality of substrates in the first posture within the cassette to align the orientation indicators of the plurality of substrates; and
a mover configured to hold the cassette in the first posture such that the cassette is capable of being moved between an upper position where the cassette is capable of being rotated by the cassette posture converter and a lower position where the cassette is capable of being aligned by the orientation aligner.

12. The substrate cassette handling apparatus of claim 11, wherein the optical path is arranged in a space provided between the cassette and the orientation aligner when the cassette is held in the upper position by the mover.

13. A substrate processing apparatus comprising:
a stage on which a cassette accommodating a plurality of substrates is placed, wherein the plurality of substrates are provided with orientation indicators, respectively;
a reflector provided at a first end of a predetermined optical path, wherein the predetermined optical path is set so as to enable a light to pass therethrough without hitting the plurality of substrates when each of the orientation indicators of the plurality of substrates is oriented in a predetermined direction;
a robot configured to transfer the cassette between the stage and a shelf provided in the substrate processing apparatus, and comprising a reflective optical sensor configured to emit the light along the optical path and to detect the light reflected from the reflector; and
a controller configured to be capable of controlling the robot to move the reflective optical sensor to a position corresponding to the optical path when checking whether or not the orientation indicators of the plurality of substrates on the stage are aligned in the predetermined direction.

14. A substrate processing method comprising:
(a) placing a cassette accommodating a plurality of substrates on a stage, wherein the plurality of substrates are provided with orientation indicators, respectively;
(b) controlling a robot to transfer the cassette between the stage and a shelf provided in a substrate processing apparatus;
(c) controlling the robot such that a reflective optical sensor provided at the robot is at a position corresponding to a predetermined optical path, wherein the predetermined optical path is set so as to enable a light to pass therethrough without hitting the plurality of substrates when each of the orientation indicators of the plurality of substrates on the stage is oriented in a predetermined direction; and
(d) controlling the reflective optical sensor to emit the light along the predetermined optical path and to sense the light reflected from a reflector provided at a first end of the predetermined optical path.

15. A non-transitory computer-readable recording medium storing a program that causes, by a computer, the substrate processing apparatus to perform:
(a) placing a cassette accommodating a plurality of substrates on a stage, wherein the plurality of substrates are provided with orientation indicators, respectively;
(b) controlling a robot to transfer the cassette between the stage and a shelf provided in a substrate processing apparatus;
(c) controlling the robot such that a reflective optical sensor provided at the robot is at a position corresponding to a predetermined optical path, wherein the predetermined optical path is set so as to enable a light to pass therethrough without hitting the plurality of substrates when each of the orientation indicators of the plurality of substrates on the stage is oriented in a predetermined direction; and
(d) controlling the reflective optical sensor to emit the light along the predetermined optical path and to sense the light reflected from a reflector provided at a first end of the predetermined optical path.
